# EUROPÄISCHE PATENTANMELDUNG

(11) **EP 1 052 775 A2**
(43) Veröffentlichungstag der Anmeldung: **15.11.2000**
(21) Anmeldenummer: 00109443.2
(22) Anmeldetag: 03.05.2000
(51) Int. Cl.: H03K 17/689

(54) **Integrierter Schaltkreis eines Leistungsschalters mit galvanisch getrennter Ansteuerung**

(30) Priorität: 12.05.1999 DE 19922121
(71) Anmelder: SIEMENS AKTIENGESELLSCHAFT, 80333 München (DE)
(72) Erfinder: Munz, Dieter, Dipl.-Ing. (FH), 91315 Höchstadt (DE); Günther, Harald, Dipl.-Ing., 90537 Feucht (DE); Staudt, Michael, Dipl.-Ing. (FH), 90469 Nürnberg (DE)

(57) **Zusammenfassung**

Die Erfindung betrifft einen integrierten Schaltkreis (1), welcher einen Leistungsschalter (6) aufweist und mit einem Schaltsignaleingangsanschluß (2) versehen ist. Von diesem aus ist ein Schaltsignalpfad (4,5) zur Steuerelektrode des Leistungsschalters (6) geführt. Der integrierte Schaltkreis weist im Schaltsignalpfad eine Vorrichtung (3) zur Potentialtrennung auf.

## Beschreibung

Die Erfindung betrifft einen integrierten Schaltkreis, welcher einen Leistungsschalter aufweist und mit einem Schaltsignaleingangsanschluß versehen ist, von welchem aus ein Schaltsignalpfad zur Steuerelektrode des Leistungsschalters geführt ist.

Aus dem vom Springer Verlag 1990 herausgegebenen Buch 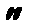 Halbleiter-Schaltungstechnik" von U. Tietze und Ch. Schenk, 9. Auflage, Seite 578-581, sind bereits Leistungsschalter bekannt. Als Bauelemente für Leistungsschalter können Bipolartransistoren, Leistungsmosfets und bei großen Leistungen im Kilowatt-Bereich auch Thyristoren oder GTO's (Gate Turn Off) verwendet werden. Eine Verwendung von Leistungsmosfets ist insbesondere deshalb von Vorteil, weil sie sich schnell ein- und ausschalten lassen. Leistungsschalter können in integrierter Form hergestellt werden.

Sind bei derartigen Leistungsschaltern die Ansteuerlogik und der Leistungsschalter auf unterschiedliche Referenzpotentiale bezogen, dann treten Potentialunterschiede auf, die auf geeignete Weise kompensiert werden müssen. Dies geschieht bisher dadurch, daß dem den Leistungsschalter realisierenden Baustein ein diskreter Optokoppler vorgeschaltet ist.

Aus der DE 197 18 420 A1 ist bereits eine integrierte Datenübertragungsschaltung mit Potentialtrennung zwischen Ein- und Ausgangsschaltkreis bekannt. Dieser werden eingangsseitig binäre Eingangssignale zugeführt, die unter Verwendung eines innerhalb der integrierten Datenübertragungsschaltung angeordneten magnetosensitiven Koppelelementes übertragen und am Ausgang der integrierten Datenübertragungsschaltung als binäre Ausgangssignale zur Verfügung gestellt werden.

Die Aufgabe der Erfindung besteht darin, einen in Form eines integrierten Schaltkreises realisierten Leistungsschalter derart weiterzubilden, daß die Gesamtschaltung, innerhalb derer er angeordnet ist, einen verringerten Stromverbrauch aufweist.

Diese Aufgabe wird durch einen integrierten Schaltkreis mit den im Anspruch 1 angegebenen Merkmalen gelöst. Vorteilhafte Ausgestaltungen und Weiterbildungen der Erfindung ergeben sich aus den abhängigen Ansprüchen.

Die Vorteile der Erfindung bestehen insbesondere darin, daß ein als integrierter Schaltkreis realisierter Leistungsschalter mit den erfindungsgemäßen Merkmalen durch die Integration der Vorrichtung zur Potentialtrennung in den Schaltsignalpfad des integrierten Schaltkreises wesentlich weniger Energie verbraucht als ein Leistungsschalter mit vorgeschaltetem Optokoppler, der mittels diskreter Bauelemente realisiert ist. Darüber hinaus benötigt ein Leistungsschalter gemäß der Erfindung bei seiner Realisierung weniger Fläche, was eine Miniaturisierung von Leistungsschaltern begünstigt. Weiterhin sind derartige Leistungsschalter auch kostengünstig zu realisieren. Ferner wird mittels der Erfindung auch der Leistungsverbrauch des Ansteuerschaltkreises gesenkt. Durch die Erfindung wird eine neue Klasse von Bauelementen zur Verfügung gestellt, welche die Funktionen eines Leistungsschalters und einer Potentialtrennung in sich vereinigen. Dieses Prinzip läßt sich auf alle gängige Leistungsschalter anwenden.

Weitere vorteilhafte Eigenschaften der Erfindung ergeben sich anhand von Ausführungsbeispielen, die nachfolgend mittels der Figuren erläutert werden: Es zeigt:
Figur 1 ein erstes Ausführungsbeispiel für die Erfindung und
Figur 2 ein zweites Ausführungsbeispiel für die Erfindung.

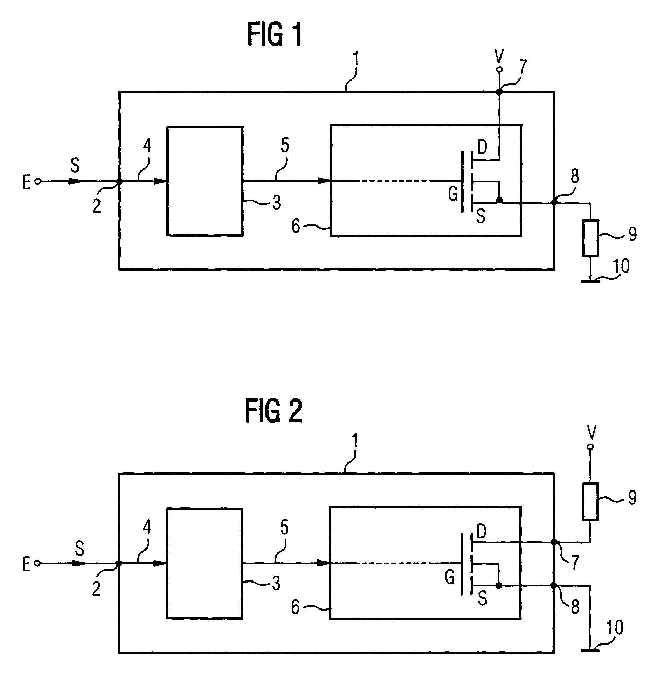

Die Figur 1 zeigt ein Blockschaltbild eines integrierten Schaltkreises 1, welcher einen Leistungsschalter 6 enthält. Dem Eingang 2 des integrierten Schaltkreises 1 wird ein an einem Eingangsanschluß E bereitgestelltes Schaltsignal S zugeführt, welches dann vom Eingang 2 des integrierten Schaltkreises 1 über einen Schaltsignalpfad 4, 5 an die Gate-Elektrode G des als Leistungsmosfet realisierten Leistungsschalters 6 weitergeleitet wird.

Die Drain-Elektrode D des Leistungsschalters 6 ist über einen Eingangsanschluß 7 des integrierten Schaltkreises 1 mit einem Eingang V für die zu schaltende Spannung verbunden.

Die Source-Elektrade S des Leistungsschalters 6 ist mit einem Ausgangsanschluß 8 des integrierten Schaltkreises verbunden. Der Ausgangsanschluß 8 ist über eine Last 9 auf Masse 10 gelegt.

Im Schaltsignalpfad 4, 5 ist eine Vorrichtung 3 zur Potentialtrennung vorgesehen, die folglich innerhalb des integrierten Schaltkreises 1 dem Leistungsschalter 6 vorgeschaltet ist. Die Vorrichtung zur Potentialtrennung weist eingangsseitig eine Leiterschleife auf, über welche das in digitaler Form vorliegende Schaltsignal geführt wird. Durch dieses digitale Signal wird im Umgebungsbereich der Leiterschleife ein Magnetfeld erzeugt, welches sich in Abhängigkeit vom digitalen Signal ändert. Dieses sich ändernde Magnetfeld wird von einem Magnetfelddetektor erkannt, der durch einen Isolator von der Leiterschleife getrennt angeordnet ist, sich aber im Bereich des genannten Magnetfeldes befindet. Das vom Magnetfelddetektor detektierte Signal wird als galvanisch von der Eingangsseite getrenntes digitales Signal der Gain-Elektrode G des Leistungsschalters 6 zur Verfügung gestellt.

Der Magnetfelddetektor der Vorrichtung 3 zur Potentialtrennung kann in Form eines Hallelementes realisiert sein. Weiterhin kann es sich bei dem genannten Magnetfelddetektor auch um einen AMR-Sensor handeln (anisotropic magnetic resistance), der auf ein sich änderndes magnetisches Feld mit einer Widerstandsveränderung reagiert. Derartige AMR-Sensoren weisen eine Permalloyschicht auf.

Zur Verbesserung der Sensitivität des Magnetfelddetektors kann dieser auch in Form eines GMR-Sensors realisiert sein (giant magnetic resistance). Derartige Sensoren weisen eine Kombination dreier Schichten auf, von denen zwei weichmagnetisch sind und eine hartmagnetisch ist.

Eine nochmalige Verbesserung der Sensitivität des Magnetfelddetektors ist dadurch möglich, daß dieser als TMR-Sensor realisiert ist (tunnelling magnetic resistance). Bei diesem ist die hartmagnetische Schicht durch eine isolierende Schicht ersetzt.

Die Figur 2 zeigt ein zweites Ausführungsbeispiel für die Erfindung. Dieses unterscheidet sich vom ersten Ausführungsbeispiel lediglich dadurch, daß die Last 9 zwischen dem Eingangsanschluß 7 des integrierten Schaltkreises 1 und dem Eingang V für die zu schaltende Spannung, die beispielsweise 24V betragen kann, angeordnet ist. Der Ausgangsanschluß 8 des integrierten Schaltkreises 1 ist bei diesem zweiten Ausführungsbeispiel direkt mit Masse 10 verbunden. Der innere Aufbau des integrierten Schaltkreises 1 gemäß dem zweiten Ausführungsbeispiel stimmt mit dem inneren Aufbau des integrierten Schaltkreises 1 gemäß dem in Figur 1 gezeigten ersten Ausführungsbeispiel ebenso überein wie dessen eingangsseitige Beaufschlagung mit dem Schaltsignal S.

Gemäß einer vorteilhaften Weiterbildung der Erfindung ist außer der Vorrichtung 3 zur Potentialtrennung weiterhin eine zusätzliche Logikschaltung in den integrierten Schaltkreis 1 integriert. Diese ist vorzugsweise ebenfalls im Schaltsignalpfad 4, 5 vorgesehen, insbesondere zwischen dem Eingangsanschluß 2 und der Vorrichtung 3 zur Potentialtrennung. Bei dieser zusätzlichen Logik kann es sich um eine SPI-Schnittstelle handeln. Weiterhin kann mittels der zusätzlichen Logik auch eine Verarbeitung des Schaltsignals S erfolgen.

Nach alledem ist gemäß der Erfindung in den Schaltsignalpfad eines in Form eines integrierten Schaltkreises realisierten Leistungsschalters eine Vorrichtung zur Potentialtrennung integriert, die vorzugsweise ein magnetosensitives Koppelelement zur potentialfreien Übertragung des Schaltsignals für den Leistungsschalter aufweist. Die Vorteile dieser Lösung bestehen insbesondere in einem reduzierten Leistungsverbrauch des Ansteuerschaltkreises, einer Einsparung von Fläche und Kosten aufgrund des kompakten Aufbaus des beanspruchten Schaltkreises und der Möglichkeit, zusätzliche Logik mit in den integrierten Schaltkreis zu integrieren.

## Patentansprüche

1. Integrierter Schaltkreis, welcher einen Leistungsschalter aufweist und mit einem Schaltsignaleingangsanschluß versehen ist, von welchem aus ein Schaltsignalpfad zur Steuerelektrode des Leistungsschalters geführt ist, **dadurch gekennzeichnet,** daß der integrierte Schaltkreis (1) im Schaltsignalpfad (4, 5) eine Vorrichtung (3) zur Potentialtrennung aufweist.

2. Integrierter Schaltkreis nach Anspruch 1, **dadurch gekennzeichnet,** daß er mit einer zusätzlichen Logikschaltung versehen ist.

3. Integrierter Schaltkreis nach Anspruch 2, **dadurch gekennzeichnet,** daß die zusätzliche Logikschaltung im Schaltsignalpfad zwischen dem Schaltsignaleingangsanschluß (2) und der Vorrichtung (3) zur Potentialtrennung angeordnet ist.

4. Integrierter Schaltkreis nach Anspruch 2 oder 3, **dadurch gekennzeichnet,** daß die zusätzliche Logik eine SPI-Schnittstelle ist.

5. Integrierter Schaltkreis nach einem der vorhergehenden Ansprüche, **dadurch gekennzeichnet,** daß die Vorrichtung (3) zur Potentialtrennung eingangsseitig eine Leiterschleife und ausgangsseitig ein Magnetfelddetektorelement aufweist.

6. Integrierter Schaltkreis nach Anspruch 5, **dadurch gekennzeichnet,** daß das Magnetfelddetektorelement ein Hallelement ist.

7. Integrierter Schaltkreis nach Anspruch 5, **dadurch gekennzeichnet,** daß das Magnetfelddetektorelement ein anisotropes, magnetoresistives Bauelement (AMR) ist.

8. Integrierter Schaltkreis nach Anspruch 5, **dadurch gekennzeichnet,** daß das Magnetfelddetektorelement ein giant magnetoresistives Bauelement (GMR) ist.

9. Integrierter Schaltkreis nach Anspruch 5, **dadurch gekennzeichnet,** daß das Magnetfelddetektorelement ein tunnel magnetoresistives Bauelement (TMR) ist.

10. Integrierter Schaltkreis nach einem der vorhergehenden Ansprüche, **dadurch gekennzeichnet,** daß der Leistungsschalter ein Leistungsmosfet (6) ist.

11. Integrierter Schaltkreis nach Anspruch 10, **dadurch gekennzeichnet,** daß der Schaltsignalpfad (4, 5) mit der Gain-Elektrode (G) des Leistungsmosfets (6) verbunden ist.

12. Integrierter Schaltkreis nach einem der vorhergehenden Ansprüche, **dadurch gekennzeichnet,** daß er einen Eingangsanschluß (7) für die zu schaltende Spannung aufweist.

13. Integrierter Schaltkreis nach einem der vorhergehenden Ansprüche, **dadurch gekennzeichnet,** daß er einen Masse-Ausgangsanschluß (8) aufweist.
